# EUROPEAN PATENT APPLICATION

(11) **EP 4 318 582 A2**
(43) Date of publication of application: **07.02.2024**
(21) Application number: 23188369.5
(22) Date of filing: 18.12.2019
(51) Int. Cl.: H01L 23/522, H01L 23/528, H01L 23/58, H01L 23/64, H01L 23/66, H01L 23/00, H10N 97/00, H03F 3/195

(54) **CHIP STRUCTURE AND WIRELESS COMMUNICATION DEVICE**

(62) Divisional of application: 19956587.0
(71) Applicant: Huawei Technologies Co., Ltd., Shenzhen, Guangdong 518129 (CN)
(72) Inventor: FAN, Jinhan, Shenzhen, Guangdong (CN); CHI, Yusong, Shenzhen, Guangdong (CN); ZHU, Nianyong, Shenzhen, Guangdong (CN)
(74) Representative: Maiwald GmbH

(57) **Abstract**

A chip structure is provided, including a die, a first chip bond pad, and a second chip bond pad. A first radio frequency module, a second radio frequency module, a first interconnect metal wire, and a second interconnect metal wire are disposed in the die. The first interconnect metal wire is connected to the first radio frequency module, and is configured to provide an alternating current ground for the first radio frequency module. The second interconnect metal wire is connected to the second radio frequency module, and is configured to provide an alternating current ground for the second radio frequency module. The first chip bond pad and the second chip bond pad are disposed on a surface of the die. The first chip bond pad is connected to the first interconnect metal wire, the second chip bond pad is connected to the second interconnect metal wire, and the first chip bond pad with the first interconnect metal wire and the second chip bond pad with the second interconnect metal wire are isolated from each other. According to the foregoing technical solution, a path through which a crosstalk signal between the first radio frequency module and the second radio frequency module propagates through the alternating current grounds is greatly extended, thereby improving isolation of a chip.

## Description

### TECHNICAL FIELD

This application relates to the field of integrated circuits, and more particularly, to a chip structure for improving isolation of a chip and a wireless communication apparatus.

### BACKGROUND

As an increasing quantity of communication modes are integrated, an increasing quantity of communication frequency bands are integrated, and chips are required to be more compact, crosstalk between modules in a chip has become a major challenge facing design of integrated circuits. For example, as increasing quantities of radio frequency transmit paths and radio frequency receive paths are integrated into an integrated circuit, especially, a radio frequency integrated circuit (RFIC), crosstalk caused by cross-coupling between radio frequency circuit modules on the RFIC becomes increasingly severe. For example, when a signal from a circuit module in a receive path that is in the RFIC and that operates on a specific frequency band is cross-coupled to a circuit module in a receive path that is in the RFIC and that operates on another specific frequency band, crosstalk caused may lead to a decrease in performance of one or more circuits adjacent to a circuit on the RFIC. Usually, a common method for overcoming this cross-coupling is to increase a distance between sensitive circuit modules on the RFIC by using an appropriate chip layout. However, on the one hand, this measure may result in a larger chip area and consequently higher costs. On the other hand, as an increasing quantity of radio frequency modules are integrated, this measure of reducing RFIC crosstalk by only optimizing the chip layout also brings quite limited benefits.

### SUMMARY

Embodiments of this application provide a chip structure for improving isolation of a chip and a wireless communication apparatus, to help improve performance.

It should be understood that in solutions provided in this application, the wireless communication apparatus may be a wireless communication device or a device in a wireless communication device, for example, an integrated circuit product such as a chip, a chip combination, or a module including a chip. These integrated circuit products may include the chip structure provided in embodiments of this application.

Specifically, the wireless communication device may be a terminal, for example, a smartphone, or may be a radio access network device, for example, a base station. Functionally, chips used for wireless communication may be classified into baseband chips and radio frequency chips. The baseband chips are also referred to as modems (modem) or baseband processing chips. The radio frequency chips are also referred to as transceiver chips, radio frequency transceivers (transceiver), or radio frequency processing chips. Therefore, the wireless communication apparatus may be a single chip or a combination of a plurality of chips, for example, a system chip, a chip platform, or a chip set.

The system chip is also referred to as a system on a chip (system on a chip, SoC) or a SoC chip for short, and may be understood as that a plurality of chips are packaged together to form a larger chip. For example, a baseband chip may be further packaged into a SoC chip. The chip platform or the chip set may be understood as a plurality of chips that need to be used together. The plurality of chips are usually packaged separately, but need to cooperate with each other during operation to jointly complete wireless communication functions. For example, a baseband chip (or a SoC chip integrated with a baseband chip) and a radio frequency chip are usually packaged separately but need to be used together.

According to a first aspect, this application provides a chip structure. The chip structure includes a die, a first chip bond pad, and a second chip bond pad. A first radio frequency module, a second radio frequency module, a first interconnect metal wire, and a second interconnect metal wire are disposed in the die. The first interconnect metal wire is connected to the first radio frequency module, and configured to provide an alternating current ground for the first radio frequency module. The second interconnect metal wire is connected to the second radio frequency module, and configured to provide an alternating current ground for the second radio frequency module. The first chip bond pad and the second chip bond pad are disposed on a surface of the die. The first chip bond pad is connected to the first interconnect metal wire, the second chip bond pad is connected to the second interconnect metal wire, and the first interconnect metal wire and the second interconnect metal wire are isolated from each other.

In the foregoing technical solution, the first interconnect metal wire and the second interconnect metal wire that are isolated from each other are disposed in the die. The two interconnect metal wires provide a different alternating current ground for the first radio frequency module and the second radio frequency module respectively, and are connected to the first chip bond pad and the second chip bond pad respectively. Therefore, a path through which a crosstalk signal between the first radio frequency module and the second radio frequency module propagates through the alternating current grounds is greatly extended, thereby improving isolation of a chip.

In a possible implementation, the chip structure further includes a redistribution layer, a first chip solder pad, and a second chip solder pad. The first chip solder pad and the second chip solder pad are disposed on a surface of the redistribution layer. A first redistribution metal wire and a second redistribution metal wire are disposed in the redistribution layer. The first chip solder pad is connected to the first chip bond pad by using the first redistribution metal wire, the second chip solder pad is connected to the second chip bond pad by using the second redistribution metal wire, and the first redistribution metal wire and the second redistribution metal wire are isolated from each other.

In the foregoing technical solution, two independent redistribution metal wires and two chip solder pads are introduced by using the redistribution layer of the chip, and therefore, the chip bond pads providing the alternating current grounds for the different radio frequency modules can be connected to different chip solder pads. In this case, the path through which the crosstalk signal between the two radio frequency modules propagates is further extended, thereby further improving isolation of the chip.

In a possible implementation, the chip structure further includes a chip redistribution layer and a first chip solder pad. The first chip solder pad is disposed on an upper surface of the redistribution layer. A first redistribution metal wire and a second redistribution metal wire are disposed in the redistribution layer. The first chip solder pad is connected to the first chip bond pad by using the first redistribution metal wire, the first chip solder pad is connected to the second chip bond pad by using the second redistribution metal wire, and the first redistribution metal wire and the second redistribution metal wire are isolated from each other.

In the foregoing technical solution, two independent redistribution metal wires are introduced in the chip redistribution layer, and therefore, the two chip bond pads providing the alternating current grounds for the different radio frequency modules are connected to a same chip solder pad. In this case, through introduction of different redistribution metal wires, the path through which the crosstalk signal between the two radio frequency modules propagates through a ground wire is further extended, thereby improving isolation of the chip.

In a possible implementation, the chip architecture further includes a first wirebond, a second wirebond, a first chip solder pad, and a second chip solder pad. The first chip solder pad is connected to the first chip bond pad by using the first wirebond, and the second chip solder pad is connected to the second chip bond pad by using the second wirebond.

In the foregoing technical solution, two different wirebonds are introduced, and therefore, the two chip bond pads providing the alternating current grounds for the different radio frequency modules are connected to different chip solder pads. In this case, through the introduction of different wirebonds and different chip solder pads, the path through which the crosstalk signal between the two radio frequency modules propagates is extended, thereby further improving isolation of the chip.

In a possible implementation, the chip architecture further includes a third chip bond pad, and the third chip bond pad is disposed on the surface of the die. A guard ring and a third interconnect metal wire are further disposed in the die, the guard ring surrounds the first radio frequency module, and the third interconnect metal wire is connected to the guard ring and configured to provide an alternating current ground for the guard ring. The third chip bond pad is connected to the third interconnect metal wire, and the third interconnect metal wire and the first interconnect metal wire are isolated from each other.

In the foregoing technical solution, an independent interconnect metal wire and a chip bond pad are disposed, and therefore, the guard ring of the first radio frequency module can have an independent alternating current ground. In this case, while noise from a substrate is reduced and performance of the first radio frequency module is improved, crosstalk signal interference caused by introduction of the guard ring is also reduced, thereby improving isolation of the chip.

In a possible implementation, the chip architecture further includes a third chip solder pad. The third chip solder pad is disposed on the upper surface of the redistribution layer. A third redistribution metal wire is disposed in the redistribution layer. The third chip solder pad is connected to the third chip bond pad by using the third redistribution metal wire, and the third redistribution metal wire and the first redistribution metal wire are isolated from each other.

In the foregoing technical solution, a dedicated redistribution metal wire and a chip solder pad are introduced and configured to be connected to the chip bond pad that provides an alternating current ground for the guard ring. In this case, the crosstalk signal interference caused by introduction of the guard ring is further reduced, thereby improving isolation of the chip.

In a possible implementation, the first radio frequency module includes a first inductive device.

In the foregoing technical solution, the first radio frequency module has stronger crosstalk energy due to introduction of an inductive device. Therefore, an isolation effect achieved by use of different interconnect metal wires, different chip bond pads, different redistribution metal wires, or different chip solder pads is more significant, and improvement of isolation performance of the chip is more obvious.

In a possible implementation, the second radio frequency module includes a second inductive device.

In the foregoing technical solution, the second radio frequency module has stronger crosstalk energy due to introduction of an inductive device. Therefore, an isolation effect achieved by use of different interconnect metal wires, different chip bond pads, different redistribution metal wires, or different chip solder pads is more significant, and improvement of isolation performance of the chip is more obvious.

In a possible implementation, the chip structure further includes a first radio frequency receive path and a second radio frequency receive path. The chip structure is configured to receive a downlink carrier aggregation signal. The downlink carrier aggregation signal includes a first component carrier and a second component carrier. The first radio frequency receive path is configured to receive the first component carrier, and the second radio frequency receive path is configured to receive the second component carrier. The first radio frequency module is disposed in the first radio frequency receive path, and the second radio frequency module is disposed in the second radio frequency receive path.

In the foregoing technical solution, because the first radio frequency module and the second radio frequency module are separately located in carrier aggregation signal radio frequency receive paths that receive different component carriers, crosstalk between each other causes a severer impact on performance of the chip. Therefore, an isolation effect achieved by use of different interconnect metal wires, different chip bond pads, different redistribution metal wires, or different chip solder pads is more significant, and improvement of isolation performance of the chip is more obvious.

In a possible implementation, the first radio frequency module is a first local oscillator, and is configured to provide a local-frequency signal for the first radio frequency receive path.

In a possible implementation, the second radio frequency module is a second local oscillator, and is configured to provide a local-frequency signal for the second radio frequency receive path.

In a possible implementation, the second radio frequency module is a second low noise amplifier, and is configured to amplify a received signal.

In a possible implementation, a third radio frequency module, a fourth radio frequency module, and a fourth interconnect metal wire are further disposed in the die. The fourth interconnect metal wire provides a common alternating current ground for the third radio frequency module and the fourth radio frequency module. A cutting slit is disposed on the fourth interconnect metal wire, and the cutting slit is located between the third radio frequency module and the fourth radio frequency module. In the foregoing technical solution, a path of signal crosstalk between the third radio frequency module and the fourth radio frequency module can also be extended by disposing the cutting slit. Therefore, isolation performance of the chip is improved without increasing difficulty of wiring.

According to a second aspect, this application further provides a wireless communication apparatus. The wireless communication apparatus includes a baseband chip and a chip that has the chip structure according to any one of the foregoing possible implementations. The baseband chip is coupled to the chip. In the foregoing technical solution, the wireless communication apparatus can extract and process digital information in received and transmitted signals through coupling between the chip and the baseband chip.

### BRIEF DESCRIPTION OF DRAWINGS

FIG. 1 is a schematic diagram of a structure of a wireless communication system according to an embodiment of this application;
FIG. 2 is a schematic diagram of a carrier configuration of a wireless communication system according to an embodiment of this application;
FIG. 3 is a schematic diagram of a structure of a wireless communication device according to an embodiment of this application;
FIG. 4 is a schematic diagram of a radio frequency chip according to an embodiment of this application;
FIG. 5 is a schematic diagram of a principle of noise interference caused to a circuit module according to an embodiment of this application;
FIG. 6 is a schematic diagram of a side view of a chip structure according to an embodiment of this application;
FIG. 7 is a schematic diagram of a top view of a chip structure according to an embodiment of this application;
FIG. 8 is a schematic diagram of a chip structure reducing electromagnetic coupling according to an embodiment of this application;
FIG. 9 is a schematic diagram of another chip structure reducing electromagnetic coupling according to an embodiment of this application;
FIG. 10 is a schematic diagram of another chip structure reducing electromagnetic coupling according to an embodiment of this application; and
FIG. 11 is a schematic diagram of a radio frequency chip with a chip structure that reduces electromagnetic coupling according to an embodiment of this application.

### DESCRIPTION OF EMBODIMENTS

The following further describes the technical solutions provided in this application with reference to the accompanying drawings and embodiments. It should be understood that a system structure and a service scenario provided in embodiments of this application are mainly intended to explain some possible implementations of the technical solutions in this application, and should not be construed as a limitation on uniqueness of the technical solutions in this application. A person of ordinary skill in the art may learn that as a system evolves and a newer service scenario emerges, the technical solutions provided in this application are still applicable to a same or similar technical problem.

It should be understood that for the technical solutions provided in embodiments of this application, some repetitions may not be described again in the following descriptions of specific embodiments, but these specific embodiments should be considered to have been referred to each other and can be combined with each other.

In a wireless communication system, devices may be classified into devices providing wireless network services and devices using wireless network services. The devices providing wireless network services are devices forming a wireless communication network, and may be referred to as network devices (network equipment) or network elements (network element) for short. The network devices are usually owned by an operator or an infrastructure provider, and are operated or maintained by these vendors. The network devices may be further classified into radio access network (radio access network, RAN) devices and core network (core network, CN) devices. Typical RAN devices include a base station (base station, BS).

It should be understood that the base station may also be referred to as a radio access point (access point, AP) or a transmission reception point (transmission reception point, TRP) sometimes. Specifically, the base station may be a general NodeB (generation Node B, gNB) in a 5G new radio (new radio, NR) system or an evolved NodeB (evolutional Node B, eNB) in a 4G long term evolution (long term evolution, LTE) system. Based on different physical forms or transmit powers of base stations, the base station may be a macro base station (macro base station) or a micro base station (micro base station). The micro base station is also referred to as a small base station or small cell (small cell) sometimes.

A device using a wireless network service may be referred to as a terminal (terminal) for short. The terminal can establish a connection to a network device, and provide a user with a specific wireless communication service based on services of the network device. It should be understood that because the terminal is more closely related to the user, the terminal is also referred to as user equipment (user equipment, UE) or a subscriber unit (subscriber unit, SU) sometimes. In addition, compared with a base station that is usually placed at a fixed location, the terminal usually moves with the user, and therefore, is also referred to as a mobile station (mobile station, MS) sometimes. Moreover, some network devices such as relay nodes (relay node, RN) or wireless routers may also be considered as terminals sometimes, because such network devices have UE identities or belong to users.

Specifically, the terminal may be a mobile phone (mobile phone), a tablet computer (tablet computer), a laptop computer (laptop computer), a wearable device (for example, a smartwatch, a smart band, a smart helmet, and smart glasses), or another device with a wireless access capability, for example, a smart car or various internet of things (internet of thing, IOT) devices, including various smart home devices (for example, a smart electric meter and a smart appliance), smart city devices (for example, a security or surveillance device and a smart road transport facility), and the like.

For ease of description, the base station and the terminal are used as examples in this application to describe the technical solutions in embodiments of this application in detail.

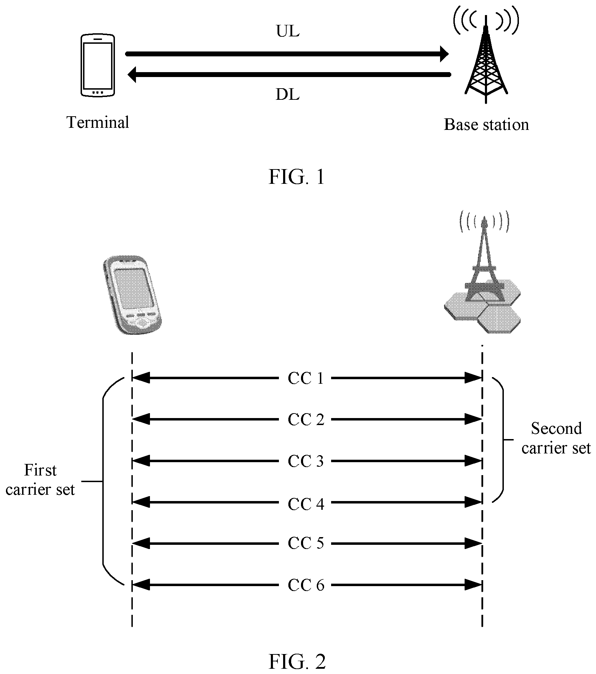

FIG. 1 is a schematic diagram of a structure of a wireless communication system according to an embodiment of this application. As shown in FIG. 1, the wireless communication system includes a terminal and a base station. Based on different transmission directions, a transmission link from the terminal to the base station is denoted as an uplink (uplink, UL), and a transmission link from the base station to the terminal is denoted as a downlink (downlink, DL). Similarly, data transmission in an uplink may be denoted as uplink data transmission or uplink transmission for short, and data transmission in a downlink may be denoted as downlink data transmission or downlink transmission for short.

In the wireless communication system, the base station can provide a specific geographic area with communication coverage by using an integrated or external antenna device. One or more terminals located within communication coverage of the base station can all access the base station. One base station can manage one or more cells (cell). Each cell has a piece of identification (identification). The identification is also referred to as a cell identity (cell identity, cell ID). From a perspective of radio resources, a cell is a combination of downlink radio resources, and uplink radio resources (optional) that are paired with the downlink radio resources.

It should be understood that the wireless communication system may comply with the wireless communication standards of the 3rd generation partnership project (third generation partnership project, 3GPP), or may comply with other wireless communication standards, for example, wireless communication standards of the 802 series (for example, 802.11, 802.15, or 802.20) of the institute of electrical and electronics engineers (Institute of Electrical and Electronics Engineers, IEEE). Although only one base station and only one terminal are shown in FIG. 1, the wireless communication system may alternatively include another quantity of terminals and another quantity of base stations. In addition, the wireless communication system may further include another network device, for example, a core network device.

The terminal and the base station should learn of configurations predefined in the wireless communication system, including a radio access technology (radio access technology, RAT) supported by the system, radio resource configurations specified in the system, and the like, for example, basic configurations of radio frequency bands and carriers. The carriers are a range of frequencies that comply with specifications of the system. The range of frequencies may be jointly determined by a carrier center frequency (denoted as a carrier frequency) and a carrier bandwidth. These configurations predefined in the system may be used as a part of a standard protocol for the wireless communication system, or may be determined through interaction between the terminal and the base station. Relevant content in the standard protocol may be pre-stored in memories of the terminal and the base station, or may be embodied as hardware circuits or software code of the terminal and the base station.

In the wireless communication system, the terminal and the base station support one or more same RATs, for example, 5G NR, 4G LTE, or an RAT of a future evolved system. Specifically, the terminal and the base station use same air interface parameters, a same coding scheme, a same modulation scheme, and the like, and communicate with each other based on radio resources specified in the system.

FIG. 2 is a schematic diagram of a carrier configuration of a wireless communication system according to an embodiment of this application. In the wireless communication system, a base station configures two carrier sets for a terminal, which are respectively denoted as a first carrier set and a second carrier set. The first carrier set may be used for downlink carrier aggregation (downlink carrier aggregation, DLCA), and the second carrier set may be used for uplink carrier aggregation (uplink carrier aggregation, ULCA). Frequency ranges of carriers included in the two carrier sets may be different, for example, a terminal operating in FDD (frequency duplex division: frequency division duplex) mode; or frequency ranges of carriers included in the two carrier sets may be the same, for example, a terminal operating in TDD (time duplex division: frequency division duplex) mode.

As shown in FIG. 2, the first carrier set includes six component carriers (component carrier, CC), which are sequentially denoted as a CC 1 to a CC 6; and the second carrier set includes four component carriers, including the CC 1 to a CC 4. It should be understood that a quantity of the CCs included in the first carrier set and a quantity of the CCs included in the second carrier set are merely for illustrative purposes. In this embodiment of this application, the first carrier set and the second carrier set may alternatively include another quantity of CCs. These CCs may be contiguous or non-contiguous in frequency domain. Different CCs may be in a same frequency band and may correspond to intra-band carrier aggregation (intra-band CA). Alternatively, different CCs may be in different frequency bands and may correspond to inter-band carrier aggregation (inter-band CA).

It should be understood that in this application, a component carrier may correspond to a serving cell (serving cell) of a terminal. In a Chinese context, the component carrier is also translated as a component carrier sometimes, and may be referred to as a carrier for short, and the serving cell may be referred to as a cell for short. Unless otherwise specified, in this application, terms "carrier", "component carrier", "aggregated carrier", "aggregated component carrier", "serving cell", "cell", "one of PCells or SCells", "one of PCCs or SCCs", and "aggregated carrier" may be used interchangeably.

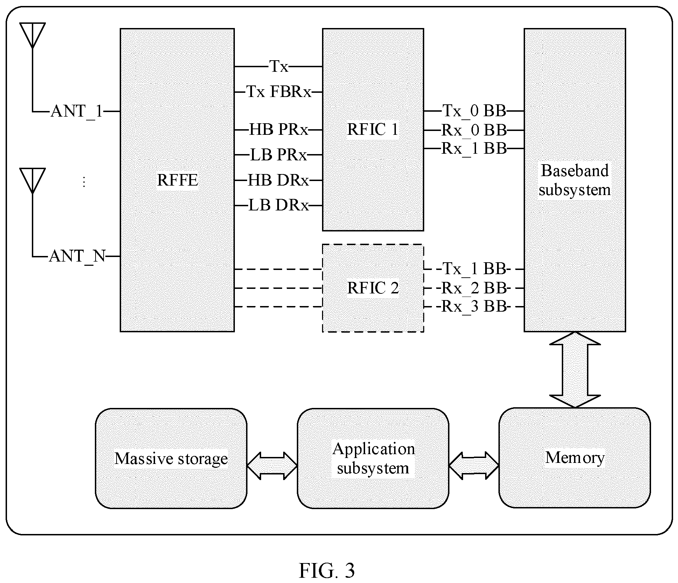

FIG. 3 is a schematic diagram of a structure of a wireless communication device according to an embodiment of this application. The wireless communication device may be the terminal or the base station in embodiments of this application. As shown in FIG. 2, the wireless communication device may include an application subsystem, a memory (memory), a massive storage (massive storage), a baseband subsystem, a radio frequency integrated circuit (radio frequency integrated circuit, RFIC), radio frequency front end (radio frequency front end, RFFE) devices, and antennas (antenna, ANT). These devices may be coupled by using various interconnect buses or in other electrical connection manners.

In FIG. 3, ANT_1 represents a first antenna, and ANT_N represents an N^{th} antenna, where N is a positive integer greater than 1; Tx represents a transmit path, Rx represents a receive path, and different numbers represent different paths; FBRx represents a feedback receive path, PRx represents a primary receive path, and DRx represents a diversity receive path; HB represents a high band, and LB represents a low band, where both indicate whether a frequency is relatively high or low; and BB represents a base band. It should be understood that the marks and the components in FIG. 3 are merely for illustrative purposes and are used merely as a possible implementation. Another implementation is further included in this embodiment of this application.

The radio frequency integrated circuit may be further divided into a radio frequency receive path (RF receive path) and a radio frequency transmit path (RF transmit path). The radio frequency receive path may receive a radio frequency signal by using an antenna, perform processing (for example, amplification, filtering, and down-conversion) on the radio frequency signal to obtain a baseband signal, and transfer the baseband signal to the baseband subsystem. The radio frequency transmit path may receive a baseband signal from the baseband subsystem, perform radio frequency processing (for example, up-conversion, amplification, and filtering) on the baseband signal to obtain a radio frequency signal, and finally radiate the radio frequency signal into space by using an antenna. Specifically, a radio frequency subsystem may include electronic devices such as an antenna switch, an antenna tuner, a low noise amplifier (low noise amplifier, LNA), a power amplifier (power amplifier, PA), a mixer (mixer), a local oscillator (local oscillator, LO), and a filter (filter). Depending on a requirement, these electronic devices may be integrated into one or more chips. The antennas may also be considered as a part of the radio frequency subsystem sometimes.

The baseband subsystem may extract useful information or data bits from a baseband signal, or convert information or data bits into a baseband signal to be transmitted. The information or data bits may be data representing user data such as speech, text, or a video or data representing control information. For example, the baseband subsystem may implement signal processing operations such as modulation, demodulation, encoding, and decoding. For different radio access technologies, for example, 5G NR and 4G LTE, baseband signal processing operations are usually not completely the same. Therefore, to support convergence of a plurality of mobile communication modes, the baseband subsystem may include a plurality of processing cores or a plurality of HACs. The baseband subsystem is usually integrated into one or more chips. A chip with the baseband subsystem integrated is usually referred to as a baseband processor chip (baseband integrated circuit, BBIC).

In addition, because radio frequency signals are analog signals, and signals processed by the baseband subsystem are mainly digital signals, the wireless communication device further needs to have analog-digital conversion devices. The analog-digital conversion devices include an analog to digital converter (analog to digital converter, ADC) that converts an analog signal into a digital signal and a digital to analog converter (digital to analog converter, DAC) that converts a digital signal into an analog signal. In this embodiment of this application, the analog-digital conversion devices may be disposed in the baseband subsystem or in the radio frequency subsystem.

The application subsystem may be used as a main control system or a main computing system of the wireless communication device, and is configured to run a main operating system and application programs, manage hardware and software resources of the entire wireless communication device, and provide users with user operation interfaces. The application subsystem may include one or more processing cores. In addition, the application subsystem may also include driver software related to another subsystem (for example, the baseband subsystem). The baseband subsystem may also include one or more processing cores, a hardware accelerator (hardware accelerator, HAC), a cache, and the like.

In this embodiment of this application, the radio frequency subsystem may include independent antennas, independent radio frequency front end (RF front end, RFFE) devices, and an independent radio frequency chip. The radio frequency chip is also referred to as a receiver (receiver), a transmitter (transmitter), or a transceiver (transceiver) sometimes. The antennas, the radio frequency front end devices, and the radio frequency processing chip may all be separately manufactured and sold. Certainly, the radio frequency subsystem may alternatively use different devices or a different integration manner, depending on requirements for power consumption and performance. For example, some of the devices belonging to a radio frequency front end are integrated into the radio frequency chip, and even the antennas and the radio frequency front end devices are all integrated into the radio frequency chip. The radio frequency chip may also be referred to as a radio frequency antenna module or an antenna module.

In this embodiment of this application, the baseband subsystem may be used as an independent chip. The chip may be referred to as a modem (modem) chip. Hardware components of the baseband subsystem may be manufactured and sold in units of modem chips. The modem chip is also referred to as a baseband chip or a baseband processor sometimes. In addition, the baseband subsystem may be alternatively further integrated into a SoC chip, and manufactured and sold in units of SoC chips. Software components of the baseband subsystem may be built into a hardware component of the chip before the chip is delivered, or may be imported into the hardware component of the chip from another nonvolatile memory after the chip is delivered, or may be downloaded and updated online by using a network.

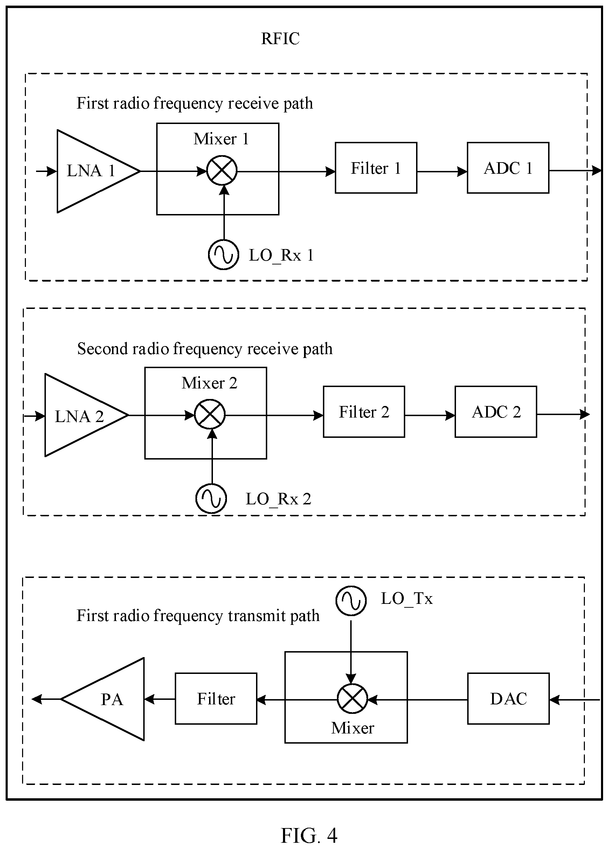

FIG. 4 is a schematic diagram of a radio frequency chip according to an embodiment of this application. It should be understood that although there are only two receive paths and one transmit path in FIG. 4, this embodiment may not be limited thereto. A radio frequency integrated circuit may include two or more transmit paths and receive paths, or another quantity of paths. The radio frequency receive path is usually used to process a received RF signal into an intermediate frequency signal. The radio frequency transmit path is usually used to process an intermediate frequency signal into a to-be-transmitted radio frequency signal. The radio frequency receive path shown in FIG. 4 includes an LNA, a mixer, a local oscillator, a filter, and an ADC. The low noise amplifier is configured to transmit an amplified radio frequency signal to the mixer. The mixer mixes the amplified radio frequency signal with a local-frequency signal provided by the LO, to obtain an intermediate frequency signal. The intermediate frequency signal passes through the filter and then is provided to the ADC. The radio frequency transmit path shown in FIG. 4 includes a DAC, a filter, a mixer, a local oscillator, and a PA. The DAC transmits an analog signal obtained through conversion to the filter. The filter then transmits the filtered signal to the mixer. The mixer mixes the filtered analog signal with a signal provided by the local oscillator, to obtain a radio frequency signal. The PA then performs power amplification on the radio frequency signal. The PA and the LNA may alternatively be located outside the radio frequency paths, and may be used as radio frequency front end devices located outside the radio frequency chip.

Usually, when two radio frequency receive paths work simultaneously, there is specific cross-coupling between radio frequency signals that are in the two radio frequency receive paths. This affects performance of the receive paths to some extent. For example, when a signal provided by a first local oscillator LO_Rx 1 in a first radio frequency receive path leaks into a second radio frequency receive path, the leaked signal may be mixed by a mixer 2 with a signal provided by a second local oscillator LO_Rx 2, and then enters a filter 2. An interference signal obtained through mixing may enter an ADC 2 through the filter 2, and finally enter a baseband, consequently affecting performance of an entire receiver. Similarly, when a first radio frequency transmit path and the first receive path work simultaneously, for example, in FDD mode, a signal leaked from a local oscillator LO_Tx or a power amplifier PA in the first radio frequency transmit path into the second radio frequency receive path also causes an interference effect similar to that existing between two radio frequency receive paths.

According to a currently used isolation measure, a manner of reducing leakage is to optimize design of a chip layout to make an interference source and an interfered functional module be as farther away from each other as possible. Although this measure of achieving isolation by increasing a distance can achieve a specific effect, an isolation effect achieved by increasing a distance is difficult to meet a requirement of a multi-path radio frequency chip as more radio frequency receive and transmit paths are integrated in a chip.

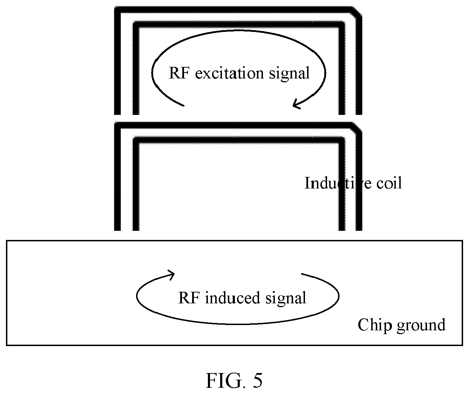

FIG. 5 is a schematic diagram of a principle of noise interference caused to a circuit module according to an embodiment of this application. Signal crosstalk inside a chip is mainly caused by magnetic field coupling. Specifically, as shown in FIG. 5, when an RF excitation signal flows through an inductive coil on a chip, magnetic lines of force perpendicular to a chip ground are generated. The magnetic lines of force electromagnetically induce a corresponding RF induced current on the chip ground. An RF induced current signal on the chip ground is coupled to different circuit modules through the chip ground. For example, a signal from the PA in the first transmit path shown in FIG. 4 induces a current signal on a chip ground by using an inductive coil of the PA. The induced current signal is coupled to an LNA or a VCO in another path through the chip ground.

Further, in a frequency range of sub 6G, a frequency band of 5G is usually higher than a frequency band of 3G or 4G. Therefore, due to an increase in an operating frequency, this "electromagnetic coupling" effect is more significant.

The inductive coil described in this embodiment is a coil structure capable of generating magnetic lines of force perpendicular to a chip ground, including but not limited to a differential inductor, a single-ended inductor, a tapped inductor, and a balun (balun) formed through coupling of two inductors.

A circuit module that needs to use an inductive coil on a chip for performing port impedance matching or generating an oscillating signal, for example, a low noise amplifier (LNA), a radio frequency power amplifier (PA), or a local oscillator (LO), may need to perform isolation processing. How to reduce electromagnetic coupling propagation of radio frequency signals from these radio frequency modules through a chip ground is an important design direction for improving isolation performance of the chip.

It should be understood that although only a magnetic field coupling effect caused by circuit modules with an inductive coil is shown in this embodiment, radio frequency modules are not limited thereto. That is, two circuit modules without a radio frequency coil that use a "common ground" also cause corresponding magnetic field coupling, resulting in a signal crosstalk problem. A difference lies only in that under same conditions, strength of coupling between radio frequency circuit modules with an inductive coil is greater than strength of coupling between radio frequency modules without an inductive coil.

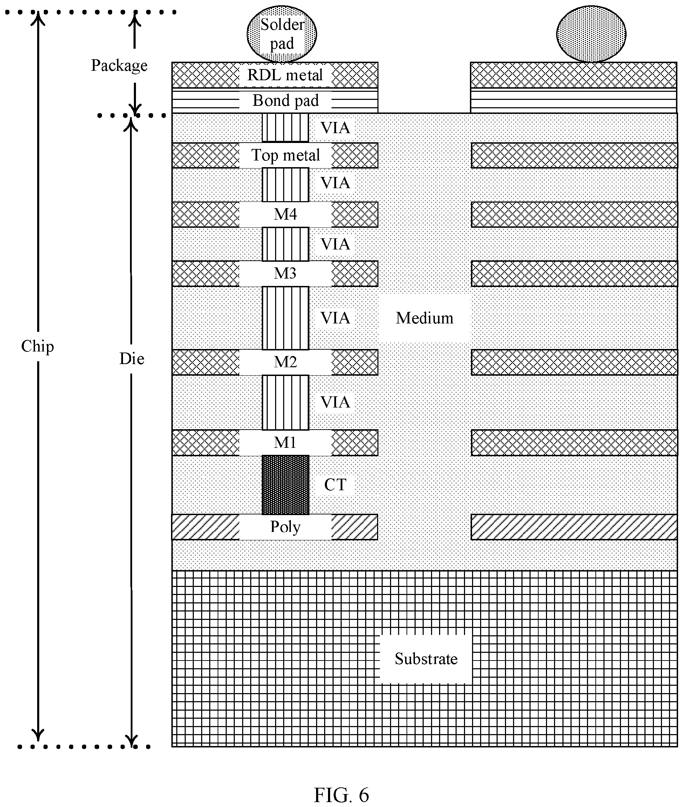

FIG. 6 is a schematic diagram of a side view of a chip structure according to an embodiment of this application. As shown in FIG. 6, a chip includes a die (die) and a package layer. As shown in the figure, the die includes a substrate and a polycrystalline silicon (poly) layer that is located on the substrate. In the substrate and the polycrystalline silicon, an active area of the chip is set, that is, an area for implementing a transistor of the chip is set. A CMOS chip is used as an example. Sources, drains, and gates of PMOS and NMOS transistors are disposed in an active area. On the poly layer, an interconnect metal layer is disposed in the die. A plurality of metal layers are disposed in the interconnect metal layer, including under metal (under metal) layers (M1, M2, M3, and M4), a top metal (top metal) layer, and a metal via (via) connecting different metal layers. Although FIG. 6 shows only five metal layers including M1, M2, M3, M4, and the top metal layer, metal layers included in the RFIC chip in this embodiment may not be limited thereto. The interconnect metal layer in the die mainly provides interconnect metal wires for circuit parts and components that are integrated on the die. The interconnect metal wires may include metal wires or metal surfaces that connect to each other and that are located on the metal layers, and may include the vias between the metal layers. Different transistors in the die may finally constitute, through connection of the interconnect metal wires, required circuit modules and systems that are in various topological structures. Usually, a thickness of the top metal layer in the die should be greater than or even several times a thickness of each of the under metal layers M1 to M4. For example, the thickness of the top metal layer may reach at least 2 µm, whereas the thickness of the under metal layers M1 to M4 usually may reach 0.5 µm or less. Alternatively, thicknesses of interconnect metal layers made by using different processes or made by different manufacturers may not be limited thereto. Therefore, in addition to a function of providing the interconnect wires, another important use of the top metal layer is to implement an on-chip inductive coil, for example, to provide an on-chip inductor or an on-chip balun (balun) for the radio frequency functional modules described in the foregoing embodiment, such as the LNA, the VCO, a DCO, and the PA. The inductive coil implemented by using the top metal layer may have a smaller internal resistance, enabling better performance for a circuit module.

Further, the package (Package) layer may be disposed on the die. The package layer is configured to package the die, so that the die is packaged into a final chip product form. The package layer may include a bond pad (bond pad) and a redistribution layer (redistribution layer, RDL) metal. The bond pad is disposed on an upper surface of the die. The bond pad is configured to implement pins that are used for external connection of the die. For example, for pins of an input port of the chip, pins of an output port of the chip, ground pins of the chip, power pins of the chip, and specific test pins of the chip, corresponding bond pads are formed on the upper surface of the die.

A redistribution layer (redistribution layer, RDL) may be disposed on the bond pad. A chip solder pad (solder pad) is disposed on the RDL. The solder pad is configured to provide a chip package-level solder joint, to implement further fixed connection between the chip and a PCB board or another package substrate. Based on a size and a process, solder pads may be classified into solder balls (solder ball), solder bumps (solder bump), and solder joints with similar functions. Different RDL metal wires are disposed in the RDL layer to provide electrical connections between bond pads and chip solder pads. An RDL metal wire is disposed between a bond pad and a solder pad, with one end disposed on an upper surface of the bond pad and the other end disposed on a lower surface of the solder pad.

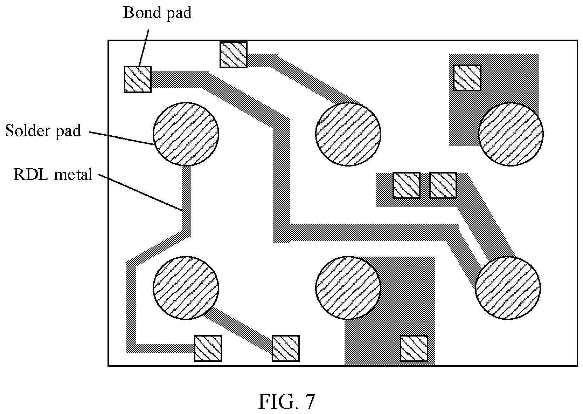

FIG. 7 is a schematic diagram of a top view of a chip structure according to an embodiment of this application. As shown in FIG. 7, a chip bond pad is square, and a chip solder pad is round. FIG. 7 is used merely as an example diagram. Shapes of the chip bond pad and the chip solder pad in this embodiment of this application are not limited thereto, and there may be more other options. As shown in FIG. 7, usually, because the chip solder pad is configured for connection and fixing between a chip and an external package substrate or a PCB board, the chip solder pad needs to withstand more hard force. Therefore, an area of a chip solder pad is greater than an area of a chip bond pad, and there are more chip solder pads than chip bond pads. Considering a limit of a quantity of the chip solder pads, there is usually a case in which a plurality of chip bond pads share one chip solder pad. Different chip solder pads and chip bond pads are connected by using different RDL metal wires.

The chip structures shown in FIG. 6 and FIG. 7 are wafer level chip scale packages (wafer level chip scale package: WLCSP). The chip structure in this embodiment may not be limited thereto. Alternatively, the chip structure in this embodiment may be a structure that is based on an existing chip packaging process in another similar form, for example, a wirebond (wirebond) or a copper pillar (copper pillar). For example, when the chip is based on the wirebond packaging process, the chip bond pads are connected to the chip solder pads by using wirebonds. When the chip is based on a package structure, for example, a copper pillar, the chip bond pads are connected to the solder pads by using similar copper pillars or vias.

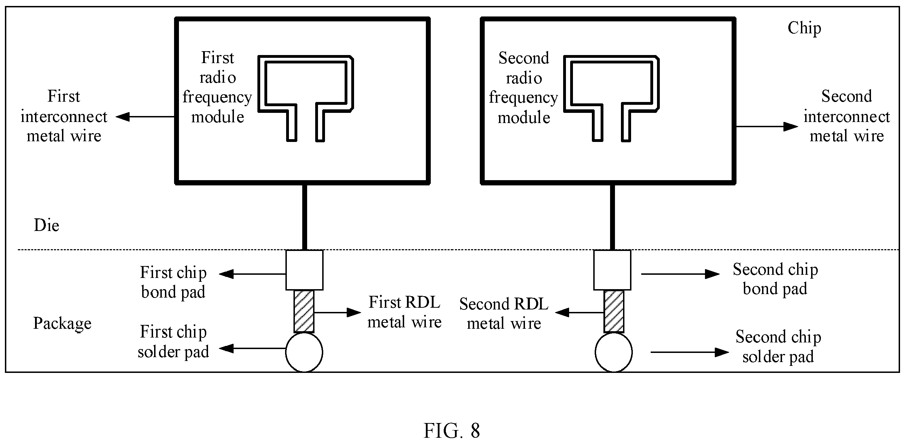

FIG. 8 is a schematic diagram of a chip structure reducing electromagnetic coupling according to an embodiment of this application. On a basis of the foregoing embodiment, as shown in FIG. 8, the chip structure includes a die and a package layer disposed on the die. Specifically, a first radio frequency module and a second radio frequency module are disposed in the die.

The first radio frequency module and the second radio frequency module may be two adjacent circuit modules without another circuit module between each other. In this case, due to a minimum distance between the two circuit modules, an impact caused by electromagnetic coupling between the two circuit modules is severest. Alternatively, the first radio frequency module and the second radio frequency module may be two circuit modules that are not adjacent but have a high requirement for isolation, for example, two radio frequency circuit modules with an inductive coil. Specifically, the first radio frequency module and the second radio frequency module may be one or two of radio frequency circuit modules LNA, VCO, DCO, and PA.

A first interconnect metal wire and a second interconnect metal wire are further disposed in the die. The first interconnect metal wire is configured to provide alternating current ground potential for the first radio frequency module. The second interconnect metal wire is configured to provide alternating current ground potential for the second radio frequency module. The first interconnect metal wire and the second interconnect metal wire may include metal traces disposed in different metal layers and vias disposed between different metal layers. The first interconnect metal wire and the second interconnect metal wire are not electrically connected to each other in the die, and are isolated from each other. Through isolation of the interconnect metal wires in the die, performance of isolation between the two circuit modules can also be improved. A reason is as follows: The first interconnect metal wire and the second interconnect metal wire that are isolated from each other in the die are disposed to provide separate alternating current grounds. In this case, a path through which a crosstalk signal propagates through the interconnect metal wires providing the ground potential is also extended, compared to a case in which a same interconnect metal wire is used in the die to provide an alternating current ground. Accordingly, isolation between the first radio frequency module and the second radio frequency module can also be improved.

Further, to further extend the crosstalk path of the interference signal between the first radio frequency module and the second radio frequency module, as shown in FIG. 8, the first interconnect metal wire and the second interconnect metal wire may also be separately connected to different bond pads. Specifically, the first interconnect metal wire may be connected to a first chip bond pad, and the first interconnect metal wire may be connected to a second chip bond pad. Through disposing of two independent bond pads, isolation between the first radio frequency module and the second radio frequency module can be improved.

Further, in a scenario in which there is a higher requirement for isolation of a chip, to further extend the crosstalk path of the interference signal between the first radio frequency module and the second radio frequency module, the first chip bond pad and the second chip bond pad may be further connected to different chip solder pads by using different RDL metal traces. Specifically, the first chip bond pad may be connected to a first chip solder pad by using a first RDL metal wire, and the second chip bond pad may be connected to a second chip solder pad by using a second RDL metal wire. Through disposing of two different solder pads in the package layer, isolation between the first radio frequency module and the second radio frequency module can be further improved, compared to that in a case in which the first chip bond pad and the second chip bond pad are connected to a same solder pad.

Still further, when the chip needs to be packaged with a package substrate into a module and then soldered to a final PCB, to further improve isolation, different chip solder pads may be further connected to different solder pads of the package substrate by using metal traces of the package substrate, to further extend the crosstalk path of the interference signal between the first radio frequency module and the second radio frequency module.

FIG. 8 shows a structure that is based on a WLCSP to improve isolation of a chip, and this embodiment may not be limited thereto. For example, when this embodiment is based on wirebond chip packaging, the chip structure may include a first wirebond, a second wirebond, a first chip solder pad, and a second chip solder pad. The first chip solder pad may be connected to the first chip bond pad by using the first wirebond, and the second chip solder pad may be connected to the second chip bond pad by using the second wirebond. Through introduction of two different wirebonds, the two chip bond pads providing the alternating current grounds for the different radio frequency modules can be connected to different chip solder pads. In this case, through introduction of different wirebonds and different chip solder pads, the path through which the crosstalk signal between the two radio frequency modules propagates is extended, thereby further improving isolation of the chip.

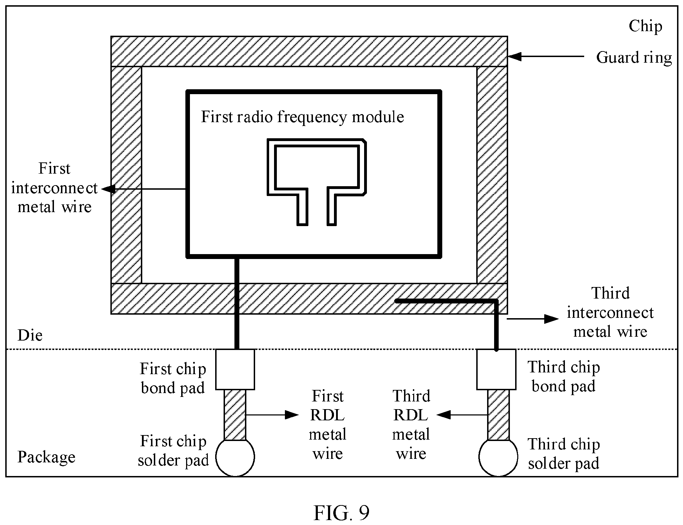

FIG. 9 is a schematic diagram of another chip structure reducing electromagnetic coupling according to an embodiment of this application. On a basis of the foregoing embodiment, the circuit module described in the foregoing embodiment may further include a guard ring (guard ring), as shown in FIG. 9. In the die, the guard ring may be configured to surround the radio frequency module, to reduce noise from a substrate of the radio frequency module. The guard ring is usually connected to a same metal wire as the radio frequency module surrounded by the guard ring. Specifically, the first interconnect metal wire of the radio frequency module is connected to both the radio frequency module and the guard ring and provides a common alternating current ground for the two. This method of connecting the guard ring aggravates high-frequency noise between adjacent circuit modules, instead of reducing it. Guard rings surrounding the radio frequency modules become propagation media of noise between circuit modules.

To this end, this embodiment proposes a new guard ring structure. As shown in FIG. 9, the guard ring may be connected to a corresponding alternating current ground by using an independent interconnect metal wire. Based on this manner of connecting the guard ring, a coupling propagation path of a coupling signal of the first radio frequency module through the guard ring can be extended on the die, thereby improving isolation of the chip. Specifically, the first interconnect metal wire and a third interconnect metal wire may be respectively connected to the first radio frequency module and the guard ring, to provide the first radio frequency module and the guard ring with their respective alternating current grounds. The first interconnect metal wire and the third interconnect metal wire are not electrically connected to each other in the die, and are isolated from each other.

Further, as shown in FIG. 9, the first interconnect metal wire and the third interconnect metal wire may be further connected to different bond pads in the package layer. Specifically, the third interconnect metal wire may be connected to a third chip bond pad, and the first interconnect metal wire may be connected to the first chip bond pad. In this way, an electromagnetic coupling effect caused by the first radio frequency module by using the guard ring can be further reduced, thereby improving isolation of the chip.

Further, in a scenario in which there is a higher requirement for isolation of a chip, to further extend the crosstalk path of the interference signal through the guard ring, the first chip bond pad and the third chip bond pad may be further connected to different chip solder pads by using different RDL metal traces. Specifically, the first chip bond pad may be connected to the first chip solder pad by using the first RDL metal wire, and the third chip bond pad may be connected to a third chip solder pad by using a third RDL metal wire.

Still further, when the chip needs to be packaged with a package substrate into a module and then soldered to a final PCB, to further improve isolation, different chip solder pads may be further connected to different solder pads of the package substrate by using metal traces on surfaces of vias of the package substrate.

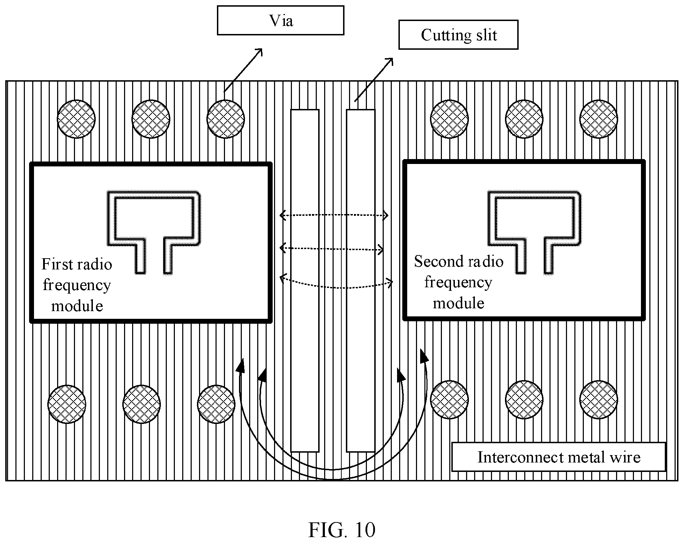

FIG. 10 is a schematic diagram of another chip structure reducing electromagnetic coupling according to an embodiment of this application. On a basis of the foregoing embodiments, electromagnetic coupling between different radio frequency modules can be reduced by using different interconnect metal wires, but this also brings specific requirements and challenges for wiring on a chip and an area of the chip. Under area and wiring constraints, in a scenario in which two different radio frequency modules cannot use independent interconnect metal wires for provision of different alternating current grounds, the two radio frequency modules have to share one interconnect metal wire for provision of an alternating current ground. Usually, to reduce a parasitic resistance and an inductive effect brought by a metal wire, an interconnect metal wire may be in a form of a metal "plane". That is, an entire metal plane is used as a connecting wire. In this embodiment, a cutting slit may be introduced to an interconnect metal wire. The cutting slit is located between two radio frequency modules, and configured to extend a path through which the two radio frequency modules propagate an interference signal through the interconnect metal wire. This is intended to improve isolation between the two radio frequency modules. Specifically, as shown in FIG. 10, the cutting slit is located on the interconnect metal wire and disposed between a first radio frequency module and a second radio frequency module. Due to existence of the cutting slit, the coupling path of the interference signal between the two radio frequency modules changes from a first path (a dashed line with two arrows) to a second path (a solid line with two arrows), thereby improving isolation between the first radio frequency module and the second radio frequency module. The cutting slit may be disposed in one or a plurality of metal layers. Further, to better provide connection to an alternating current ground, an interconnect metal wire on a metal layer may have a plurality of vias for connection to an interconnect metal wire on another metal layer.

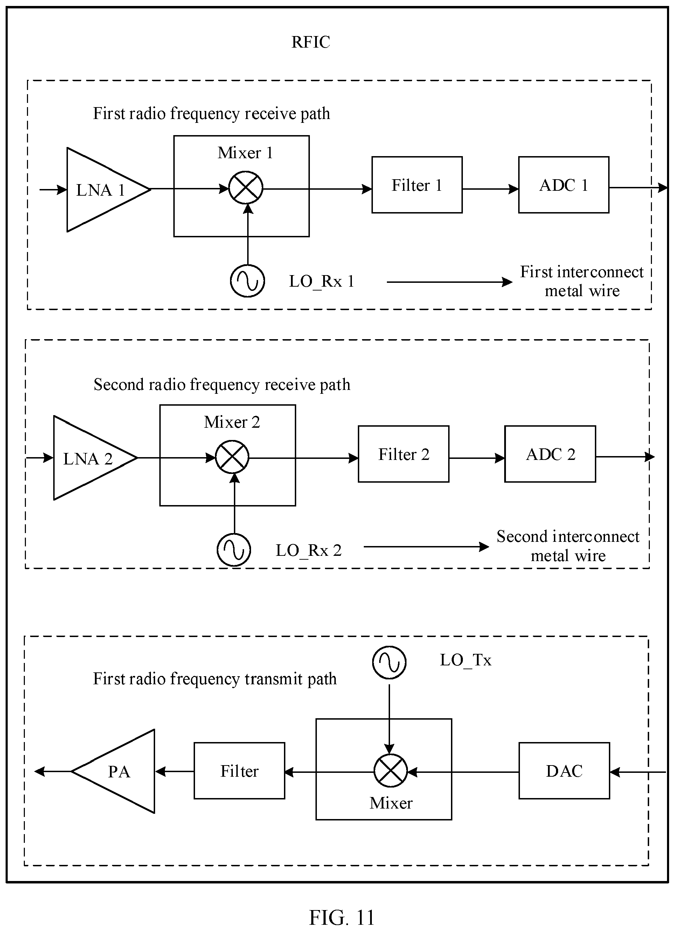

FIG. 11 is a schematic diagram of a radio frequency chip with a chip structure that reduces electromagnetic coupling according to an embodiment of this application. On a basis of the foregoing embodiments, different interconnect metal wires provide different alternating current grounds, and this can reduce electromagnetic coupling between different circuit modules. However, if the chip structure reducing electromagnetic coupling proposed in embodiments of this application is used between every two radio frequency modules, an excessively heavy penalty is paid in an area and wiring complexity of a radio frequency chip. Therefore, the following is a factor that needs to be considered during design of a radio frequency chip: identifying radio frequency modules that are highly sensitive to electromagnetic coupling, and then introducing the chip structure reducing electromagnetic coupling in embodiments of this application in a targeted manner.

A typical scenario of radio frequency interference is interference between radio frequency modules in different receive paths in a case of DLCA. As shown in FIG. 11, a first receive radio frequency path is configured to receive a first carrier CC 1, and a second receive radio frequency path is configured to receive a second carrier CC 2. Crosstalk caused by LOs in the two paths, namely, coupling crosstalk caused by an LO_RX 1 and an LO_RX 2 shown in FIG. 11 to modules in the radio frequency paths, has a severe impact on performance of the radio frequency chip. For example, typical commercial DLCA includes two CCs, with a CC 1 being Band 46 (5300 MHz) and a CC 2 being Band 7 (2650.5 MHz). Usually, a frequency of a signal provided by the LO_RX 2 that corresponds to the CC 2 in the second radio frequency receive path is twice a center frequency of the CC 2, that is, 5301 MHz. If being coupled to an input terminal of a mixer 1 in the first receive radio frequency path, the signal provided by the LO_RX 2 is down-converted into a 1 MHz baseband signal, resulting in a decrease in receiver sensitivity of the first receive path. Therefore, the chip structure reducing electromagnetic coupling in embodiments of this application may be considered to be introduced between the LO_RX 2 in the second receive path and a radio frequency module located before the mixer 1 in the first receive path, for example, the LO_RX 1, an LNA 1, or the mixer 1. Specifically, the LNA 1 in the first radio frequency receive path configured to receive a first carrier signal may be connected to a first interconnect metal wire, and the LO_RX 2 in the first radio frequency receive path configured to receive a first carrier signal may be connected to a first interconnect metal wire. The first interconnect metal wire is configured to provide an alternating current ground for the LNA 1, and the second interconnect metal wire is configured to provide an alternating current ground for the LO_RX 2. The first interconnect metal wire and the second interconnect metal wire are not electrically connected to each other in a die, and are isolated from each other. Further, the LNA 1 may further include a guard ring. The guard ring is connected to a third interconnect metal wire. The third interconnect metal wire and the first interconnect metal wire are not electrically connected to each other in the die, and are isolated from each other.

Further, a structure in which different bond pads and solder pads are used in the package layers in the foregoing embodiments to further reduce coupling between circuit modules may also be applied to the LNA 1 and the LO_RX 2.

Similarly, a structure similar to the foregoing structure that improves isolation of a chip may be introduced between the mixer 1 and the LO_RX 2 and between the LO_RX 1 and the LO_RX 2.

It should be understood that the alternating current ground described in embodiments of this application is a concept of a ground in an alternating current signal, and the alternating current ground may correspond to a power supply and a ground in a direct current. The interconnect metal wires in embodiments of this application may be metal wires with significant differences in length and width, or may be a concept of a "plane" with a purpose of further reducing a parasitic resistance and a parasitic capacitance.

It should be understood that in embodiments of this application, the baseband subsystem and the radio frequency subsystem jointly form a communication subsystem to provide a wireless communication function for the wireless communication device. Usually, the baseband subsystem is responsible for managing software and hardware resources of the communication subsystem, and may configure operating parameters of the radio frequency subsystem. One or more processing cores of the baseband subsystem may be integrated as one or more chips. The chip may be referred to as a baseband processing chip or a baseband chip. Similarly, the RFIC may be referred to as a radio frequency processing chip or a radio frequency chip. In addition, as technologies evolve, division of functions of the radio frequency subsystem and the baseband subsystem in the communication subsystem may also be adjusted. For example, some functions of the radio frequency subsystem are integrated into the baseband subsystem, or some functions of the baseband subsystem are integrated into the radio frequency subsystem. In actual application, depending on a requirement of an application scenario, the wireless communication device may use combinations of different quantities and different types of processing cores.

It should be understood that sequence numbers of the foregoing processes do not mean execution sequences in this application. The execution sequences of the processes should be determined according to functions and internal logic of the processes, and should not be construed as any limitation on the implementation processes of embodiments of this application. The term "coupling" mentioned in this application is used to indicate interworking or interaction between different components, and may include a direct connection or an indirect connection by using another component.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

It is clear that a person skilled in the art can make various modifications and variations to this application without departing from the scope of this application. In this way, if these modifications and variations to this application fall within the scope of the claims of this application and their equivalent technologies, this application is also intended to cover these modifications and variations.

## Claims

1. A chip structure, comprising:
a die;
a first radio frequency module, a second radio frequency module, and an interconnect metal wire disposed in the die; wherein
the first radio frequency module and the second radio frequency module share the interconnect metal wire for provision of an alternating current ground; and
a cutting slit located on the interconnect metal wire, and the cutting slit is disposed between the first radio frequency module and the second radio frequency module.

2. The chip according to claim 1, wherein the first radio frequency module is disposed in a first radio frequency receive path, and the second radio frequency module is disposed in a second radio frequency receive path, and the first radio frequency receive path and the second radio frequency receive path are disposed in the die;
the first radio frequency receive path and the second radio frequency receive path are configured to receive a downlink carrier aggregation signal comprising a first component carrier and a second component carrier, wherein the first radio frequency receive path is configured to receive the first component carrier; and the second radio frequency receive path is configured to receive the second component carrier.

3. The chip according to either of claims 1 and 2, wherein the interconnect metal wire is a metal plane.

4. The chip according to any one of claims 1 to 3, further comprising:
a first chip bond pad coupled to the first radio frequency module, and a second chip bond pad coupled to the second radio frequency module, the first chip bond pad and the second chip bond pad are disposed on a surface of the die.

5. The chip according to claim 4, further comprising: a redistribution layer, a first chip solder pad, and a second chip solder pad, wherein
the first chip solder pad and the second chip solder pad are disposed on an upper surface of the redistribution layer; a first redistribution metal wire and a second redistribution metal wire are disposed in the redistribution layer; the first chip solder pad is connected to the first chip bond pad by using the first redistribution metal wire, and the second chip solder pad is connected to the second chip bond pad by using the second redistribution metal wire, and the first redistribution metal wire and the second redistribution metal wire are isolated from each other.

6. The chip according to claim 4, further comprising:
a chip redistribution layer, and a first chip solder pad, wherein
the first chip solder pad is disposed on an upper surface of the redistribution layer; a first redistribution metal wire and a second redistribution metal wire are disposed in the redistribution layer; the first chip solder pad is connected to the first chip bond pad by using the first redistribution metal wire, the first chip solder pad is connected to the second chip bond pad by using the second redistribution metal wire, and the first redistribution metal wire and the second redistribution metal wire are isolated from each other.

7. The chip according to either of claims 5 and 6, further comprising:
a third chip solder pad, wherein
the third chip solder pad is disposed on the upper surface of the redistribution layer; a third redistribution metal wire is disposed in the redistribution layer; the third chip solder pad is connected to the third chip bond pad by using the third redistribution metal wire, and the third redistribution metal wire and the first redistribution metal wire are isolated from each other.

8. The chip according to any one of claims 1 to 7, wherein
the first radio frequency module comprises a first inductive device.

9. The chip according to any one of claims 1 to 8, wherein
the second radio frequency module comprises a second inductive device.

10. The chip according to claim 2, wherein
the first radio frequency module is a first local oscillator, and is configured to provide a local-frequency signal for the first radio frequency receive path.

11. The chip according to claim 10 wherein
the second radio frequency module is a second local oscillator, and is configured to provide a local-frequency signal for the second radio frequency receive path.

12. The chip according to claim 10, wherein
the second radio frequency module is a low noise amplifier.

13. The chip according to any one of claims 1 to 11, wherein the chip is a radio frequency integrated circuit, RFIC.

14. A wireless communication apparatus, comprising:
a baseband chip and a chip having the chip structure according to any one of claims 1 to 13, wherein
the baseband chip is coupled to the chip.
